# EUROPÄISCHE PATENTSCHRIFT

(11) **EP 1 842 407 B1**
(45) Veröffentlichungstag und Bekanntmachung des Hinweises auf die Patenterteilung: **06.04.2011**
(21) Anmeldenummer: 06700718.7
(22) Anmeldetag: 17.01.2006
(51) Int. Cl.: H05K 5/00

(54) **STEUERMODUL**
CONTROL MODULE
MODULE DE COMMANDE

(30) Priorität: 20.01.2005 DE 102005002813
(43) Veröffentlichungstag der Anmeldung: 10.10.2007
(73) Patentinhaber: ROBERT BOSCH GMBH, 70442 Stuttgart (DE)
(72) Erfinder: WETZEL, Gerhard, 70825 Korntal-muenchingen (DE); SPRAFKE, Peter, 70469 Stuttgart (DE)
(86) Internationale Anmeldenummer: PCT/EP2006/050241
(87) Internationale Veröffentlichungsnummer: WO 2006/077208

(56) Entgegenhaltungen:
- EP-A- 1 239 710
- DE-A1- 19 907 949
- DE-C1- 10 051 945
- US-A- 5 586 388

## Beschreibung

### Stand der Technik

Die Erfindung betrifft ein Steuermodul, insbesondere zur ein Steuermodul für ein Kraftfahrzeuggetriebe mit den Merkmalen des Oberbegriffs des unabhängigen Anspruchs 1.

Ein Steuermodul mit den Merkmalen des Oberbegriffs des Anspruchs 1 ist beispielsweise aus der DE 199 07 949 A1 bekannt. Derartige Steuermodule sind dazu ausgebildet, an einer Kraftfahrzeugkomponente wie dem Getriebe oder dem Motor festgelegt zu werden, und weisen verschiedene, der Kraftfahrzeugkomponente zugeordnete Bauteile auf Steuermodule für Automatikgetriebe weisen beispielsweise ein Hybridsteuergerät mit einem elektronischen Schaltungsteil, Sensoren und mindestens eine Steckverbindung zum Anschluss an den Fahrzeugkabelbaum auf und werden teilsweise derart am Getriebe angeordnet, dass sie dem Getriebefluid und den dort herrschenden hohen Temperaturen von bis zu 150°C ausgesetzt sind. Um das empfindliche elektronischen Schaltungsteil zu schützen, ist eine öldichte Verkapselung desselben erforderlich. Das bekannte Steuermodul weist hierzu eine Bodenplatte als erstes Gehäuseteil auf, die seitlich durch einen Kunststoffträger flächig fortgesetzt wird. Eine flexible Leiterfolie ist auf den Kunststoffträger und die Bodenplatte auflaminiert. Auf die Leiterfolie wird ein Deckel mit einer eingelegten Dichtung als zweites Gehäuseteil aufgelegt Die Leiterfolie ist im Gehäuseinnenraum mit einem auf die Bodenplatte aufgebrachten elektronischen Schaltungsteil über Bonddrähte elektrisch verbunden. Da die flexible Leiterfolie zur Abdichtung mit der Bodenplatte verklebt wird, muss das relativ große Verbundteil aus Bodenplatte und Kunststofflräger bei der Herstellung der Bonddrahtverbindungen, beim Abgleich der Schaltung und bei weiteren Fertigungsschritten die komplette Elektronikfertigung durchlaufen.

### Vorteile der Erfindung

Das erfindungsgemäße Steuermodul mit den kennzeichnenden Merkmalen des Anspruchs 1 erfordert besonders wenig Montageaufwand und ist kostengünstig herstellbar. Durch einen stapelförmigen Aufbau, bei dem der Träger mit einer ersten Seite auf einer mit dem Schaltungsteil versehenen Innenseite des ersten Gehäuseteils aufliegend angeordnet ist, das Schaltungsteil in einer Aussparung des Trägers angeordnet ist, die flexible Leiterfolie auf der von dem ersten Gehäuseteil abgewandten zweiten Seite des Trägers angeordnet ist und das zweite Gehäuseteil auf die flexible Leiterfolie aufgesetzt ist, entfällt die Notwendigkeit die flexible Leiterfolie auf das mit dem Schaltungsteil versehene erste Gehäuseteil auflaminieren zu müssen und es wird in besonders vorteilhafte Weise erreicht, dass das Steuermodul im wesentlichen aus einer Baugruppe für die Verbindungsfunktionen und einer Baugruppe für die Elektronikfunktionen und einem Deckelteil zusammengesetzt werden kann, wobei die beiden Baugruppen in besonders vorteilhafter Weise getrennt voneinander gefertigt und vorgeprüft werden können und anschließen einfach gestapelt werden. Die elektrische Schnittstelle zwischen den beiden Baugruppen kann dabei so gestaltet sein, dass eine einfache und robuste elektrische Verbindung der beiden Baugruppen möglich ist.

Da die Baugruppe für die Elektronikfunktionen ohne die flexible Leiterfolie hergestellt werden kann, ist diese kostengünstiger herstellbar, da die Bestückung des elektronischen Schaltungsteils und die Kontaktierung der elektronischen Bauelemente mit den Leiterbahnen des Schaltungsteils mittels Bonddrähten in Einzelsubstratfertigung erfolgen kann. Hierzu wird beispielsweise ein LTCC-Substrat (Low temperature cofired ceramic) im Nutzen gefertigt und in Einzelsubstrate aufgeteilt, die dann einzeln auf jeweils eine das erste Gehäuseteil bildende, kleine und ebene metallische Grundplatte, vorzugsweise eine Aluminiumplatte, aufgeklebt werden. Als fehlerhaft identifizierte LTCC-Substrate werden nach dem Vereinzeln sofort aussortiert werden. Die jeweils aus einer Grundplatte und einem LTCC-Substrat bestehenden vereinzelten Baugruppen werden anschließend mit elektronischen Bauelementen bestückt. Die elektrische Kontaktierung der Bauelemente mit dem Substrat kann mittels Goldbonddrähten oder in andere geeigneter Weise erfolgen. Aufgrund der kleinen Abmessung der Grundplatte können die Prozesse Bestücken und Bonden auf Standardmaschinen durchgeführt werden. Anschließend kann die Baugruppe verschiene Funktionsprüfungen durchlaufen, die teilsweise unter sehr hohen und tiefen Temperaturen von 120°C bis -20°C durchgeführt werden. Da die Baugruppe eine sehr kleine Masse hat, sind Erwärmung und Abkühlung schnell durchführbar. Die Baugruppe für die Elektronikfünktionen des Steuermoduls kann weitgehend als Standardbauteil hergestellt werden und unabhängig von der für die Verbindungsfunktionen vorgesehenen Baugruppe durch eine Baugruppe mit einem anderen Standard aber gleichen geometrischen Abmessungen ersetzt werden.

Die Baugruppe für die Verbindungsfunktionen umfasst den Träger und die darauf aufbrachte flexible Leiterfolie und Sensoren, Stecker und gegebenenfalls eine zusätzliche Abdeckung. Die Funktionalität dieser Baugruppe kann unabhängig von der Baugruppe für die Elektronikfunktionen geprüft werden. Vorteilhaft können einzelne elektrische Bauelemente, wie Kondensatoren mit Drahtanschlüssen innerhalb einer Aussparung des Trägers eingebracht werden und mit der Leiterfolie kontaktiert werden, so dass diese Bauelemente im fertigen Steuermodul innerhalb des Gehäuseinnenraumes angeordnet und vor Verunreinigung und Temperaturwechselbelastungen geschützt sind. Elektronische Bauelemente können aber auch direkt auf die Leiterbahnen der flexiblen Leiterfolie beispielsweise durch Löten, Leitkleben oder Bonden aufgebracht werden. Da die Bestückung während der Herstellung der Baugruppe für die Verbindungsfunktionen vorgenommen wird, muss keine Rücksicht auf die feinen Strukturen des LTCC-Substrat genommen werden, so kann beispielsweise Flussmittel nicht das LTCC-Substrat verunreinigen. Im fertigen Steuermodul sind die Bauteil jedoch im dichten Gehäuseinnenraum geschützt untergebracht.

Die beiden Baugruppen können nach ihrer Herstellung einfach übereinander gelegt werden. Die elektrische Verbindung erfolgt vorzugsweise über Bonddrähte, welche das LTCC-Substrat mit der flexiblen Leiterfolie verbinden. Nach einer Gelbefüllung, bei der Gel in die Aussparung des Trägers appliziert wird, in der auch das LTCC-Substrat angeordnet ist, kann der Gel ausgehärtet werden. Anschließend wird das als Deckel anzusehende zweite Gehäuseteil auf die Leiterfolie aufgelegt Eine separate Öffnung zur Einfüllung des Gels, welche durch eine separate Dichtung verschlossen werden müsste, kann vorteilhaft entfallen. Der so gebildete Stapel wird schließlich mittels Befestigungselementen zusammengehalten.

### Zeichnungen

Ausführungsbeispiele der Erfindung sind in den Zeichnungen dargestellt und werden in der nachfolgenden Beschreibung erläutert. Es zeigt
- Fig. 1: einen Querschnitt durch ein erstes Ausführungsbeispiels des erfindungsgemä- β en Steuermoduls,
- Fig. 2: die Herstellung des Ausführungsbeispiels aus Fig. 1,
- Fig. 3: die Herstellung eines zweiten Ausführungsbeispiels,
- Fig. 4: einen Teilausschnitt eines Querschnitts durch ein viertes Ausführungsbeispiel,
- Fig. 5: einen Teilausschnitt eines Querschnitts durch ein fünftes Ausführungsbeispiel,
- Fig. 6: einen Querschnitt durch ein sechstes Ausführungsbeispiel,
- Fig. 7: einen Querschnitt durch ein siebtes Ausführungsbeispiel.

### Beschreibung der Ausführungsbeispiele

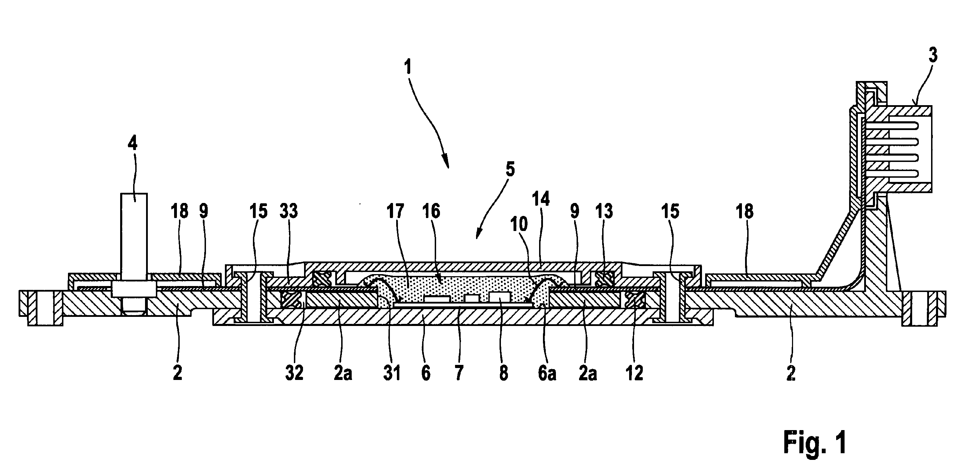

Fig. 1 zeigt einen Querschnitt durch ein erstes Ausführungsbeispiel des erfindungsgemäßen Steuermoduls. Das Steuermodul 1 umfasst einen Träger 2 aus Metall oder Kunststoff der beispielsweise am Getriebe eines Kraftfahrzeuges festlegbar ist und an dem verschiedene Bauelemente, wie beispielsweise Sensoren 4, ein Steckerteil 3 und gegebenenfalls nicht dargestellte Hydraulikventile zur Ansteuerung von Stellgfiedern des Getriebes sowie ein Getriebesteuergerät 5 festgelegt sind. Das Steuergerät 5 weist ein erstes Gehäuseteil 6, welches vorzugsweise als metallische Grundplatte aus beispielsweise Aluminium ausgebildet ist. Auf die Innenseite 6a des ersten Gehäuseteils 6 ist ein elektronisches Schaltungsteil 7, beispielsweise ein LTCC-Substrat (Low temperature cofired ceramic), das mit elektronischen Bauelementen 8 bestückt ist, aufgeklebt. Die Bauelemente 8 können über Goldbonddrähte mit den Leiterbahnen des LTCC-Substrats verbunden sein. Das Schaltungsteil 7 ist mit einer flexiblen Leiterfolie 9 über beispielsweise als Aluminium-Bonddrähte 10 ausgebildete Kontaktelemente verbunden. Die flexible Leiterfolie 9 kann aus einer der üblichen Trägerfolien aus Polyimid bestehen, die Leiterbahnen aus Kupfer tragen und im Fotoprozess strukturiert und durch Ätzen ausgebildet sind und mittels eines Schutzüberzugs oder einer weiteren Folie nach außen isoliert sind.

Wie in Fig. 1 weiterhin zu erkennen ist, ist die großflächige flexible Leiterfolie 9 auf einen Träger 2, 2a aufgebracht, der in dem ersten Ausführungsbeispiel zweiteilig ausgebildet ist und ein rechteckförmiges Rahmenteil 2a aus beispielsweise Kunststoff, sowie ein das Rahmenteil 2a umgebendes und dieses in einen Abstand fortsetzendes Stützteil 2 aus Metall oder Kunststoff aufweist. Der Träger und die Leiterfolie 9 weisen eine rechteckförmige Aussparung 31 zur Aufnahme des Schaltungsteils 7 auf Die flexible Leiterfolie 9 liegt an der von dem ersten Gehäuseteil 6 abgewandten Seite des Rahmenteils 2a an und kann dort beispielsweise mittels eines Klebers befestigt sein. Außerdem liegt die flexible Leiterfolie 9 auf der von dem ersten Gehäuseteil abgewandten Seite des Stützteils 2 an und ist dort außerhalb des zweiten Gehäuseteils 14 durch eine Abdeckung 18 befestigt, welche die Leiterfolie an das Stützteil andrückt Die Abdeckung 18 kann gleichzeitig auch zur Festlegung des Steckerteils 3 und der Sensoren 4 eingesetzt werden. Zwischen dem Rahmenteil 2a und dem Stützteil 2 ist ein umlaufender Zwischenraum 32 vorgesehen, in den ein umlaufendes erstes Dichtelement 12 (beispielsweise ein elastischer Dichtungsring) angeordnet ist, das einerseits an der Innenseite 6a des ersten Gehäuseteils 6 und andererseits an der flexiblen Leiterfolie 9 dichtend anliegt.

Aufdie flexible Leiterfolie 9 ist ein als Deckelteil vorgesehenes zweites Gehäuseteil 14 aufgesetzt, das beispielsweise ein aus Kunststoff hergestelltes Spritzgussteil oder ein metallisches Deckelteil sein kann. In einer Nut des zweitens Gehäuseteils 14 ist ein umlaufendes zweites Dichtelement 13 angeordnet, das einerseits an dem Gehäuseteil 14 und andererseits an der Leiterfolie 9 dichtend anliegt. Das zweite Dichtelement 14 weist einen etwas kleineren Durchmesser als das erste Dichtelement 13 auf, so dass die beiden Dichtelemente nicht übereinander liegen, sondern versetzt zueinander angeordnet sind.

Der aus dem ersten Gehäuseteil 6, dem Träger 2, der großflächigen Leiterfolie 9 und dem zweiten Gehäuseteil 14 gebildete Stapel ist an den Rändern des ersten und zweiten Gehäuseteils mit mehreren durchgehenden Ausnehmungen versehen, in die Befestigungselemente 15 in Form von Nieten, Schrauben, Rastmitteln oder ähnlichen Mitteln eingesetzt sind. Durch die Befestigungselemente 15 wird der Stapel zusammengedrückt, so dass das zweite Gehäuseteil 14 das elastische zweite Dichtelement 13 gegen die Oberseite der Leiterfolie 9 andrückt die sich an dieser Stelle an dem Rahmenteil 2a abstützt, und das erste Gehäuseteil 6 das elastische erste Dichtelement 12 gegen die Unterseite der Leiterfolie 9 andrückt, die sich an dieser Stelle an einem umlaufenden Kragen 33 des zweiten Gehäuseteils 14 abstützt. Auf diese Weise wird mittels nur zweiter Dichtelemente ein öldichter Gehäuseinnenraum 16 gebildet, in dem das Schaltungsteil 7 und die Bondrähte 10 geschützt angeordnet sind. Die Bauelemente 8 des elektronischen Schaltungsteils 9 sind mittels eines in die Aussparung 31 eingebrachten Abdeckmaterials 17, beispielsweise ein Gel, in bekannter Weise passiviert.

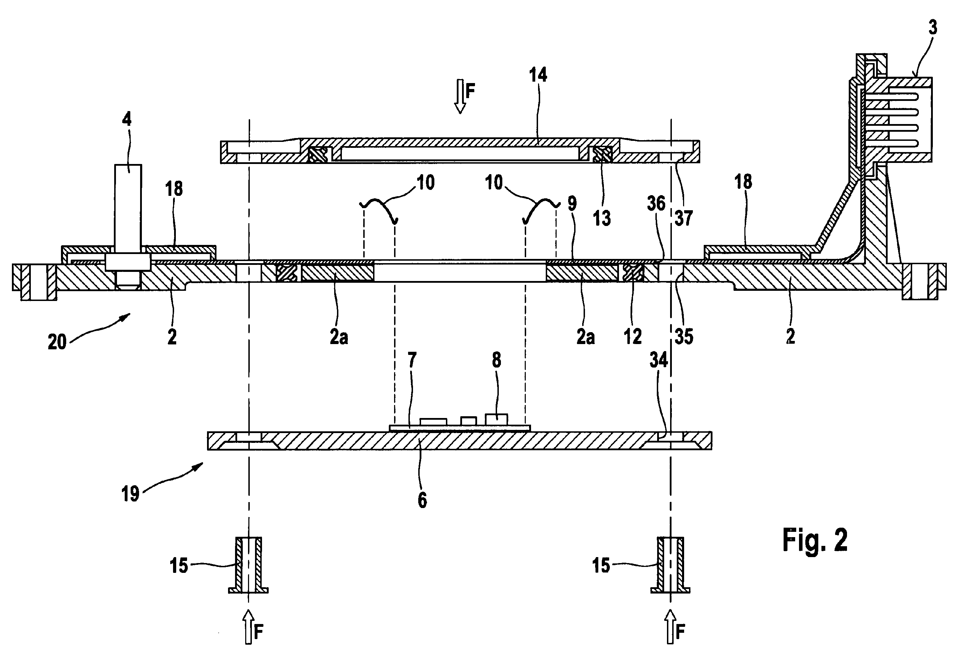

Fig. 2 zeigt wie das erste Ausführungsbeispiel des erfindungsgemäßen Steuermodul mittels vorprüfbarer modularer Baugruppen hergestellt werden kann. Eine erste Baugruppe 19 für die Elektronikfunktionen umfasst das erste Gehäuseteil 6 und das darauf aufgeklebte elektronische Schaltungsteil 7. Die Herstellung dieser Baugruppe erfolgt, indem ein im Nutzen hergestelltes LTCC-Großsubstrat in Einzelsubstrate vereinzelt wird, die auf die Gehäuseteile 6 aufgeklebt werden. Anschließend werden Bauelemente 8 auf die LTCC-Substrate bestückt und mittels Bonddrähte mit den Leiterbahnen des Substrats kontaktiert. Diese Prozesse können aufgrund der relativ kleinen räumlichen Ausdehnung des ersten Gehäuseteils auf Standardmaschinen ausgeführt werden. Schließlich wird die Funktionalität der fertigen Baugruppe 19 geprüft. Die zweite Baugruppe 20 für die Verbindungsfunktionen umfasst das Stützteil 2 aus Kunststoff oder Metall, an dem Steckerteile 3 und Sensoren 4 festegelegt werden, und ein in eine rechteckförmige Aussparung des Stützteils 2 eingelegtes rechteckförmiges Rahmenteil 2a, das erste Dichtelement 12 und die großflächige flexible Leiterfolie 9. Bei der Herstellung wird zunächst die Leiterfolie 9 in ihrem Innenbereich mit dem umlaufenden Rahmenteil 2a verklebt. Anschließend wird die Leiterfolie mit ihrem äußeren Umfangsbereich auf das Stützteil 2 aufgelegt und dann die Abdeckung 18 auf die Leiterfolie 9 aufgesetzt. Schließlich werden das Steckerteil 3 und die Sensoren 4 mit der Leitefolie elektrisch verbunden.

Die Endmontage des Steuermoduls erfolgt durch Stapeln der Baugruppen 19 und 20, wobei die Befestigungselemente 15 als Zentrierhilfen und Fügemittel dienen. Hierzu können wie in Fig. 2 gezeigt zunächst die Befestigungselemente auf einen Werkstückträger positioniert werden. Auf diese wird dann zunächst die erste Baugruppe 19 aufgesetzt, so dass die Befestigungselemente 15 die Ausnehmungen 34 der Grundplatte durchdringen. Dann wird die zweite Baugruppe 10 aufgesetzt, so dass das Rahmenteil 2a und das erste Dichtelement 12 auf der Innenseite 6a des ersten Gehäuseteils 6 positioniert wird. Das Rahmenteil 2a wird über in dem Gehäuseteil 6 eingeprägte Zapfen oder eine Verklebung zwischen Rahmenteil 2a und Gehäuseteil 6 fixiert. Die Befestigungselemente 15 greifen durch Ausnehmungen 35 im Stützteil 2 und Ausnehmungen 36 in der Leiterfolie 9. Schließlich werden die beiden Baugruppen mittels der Bonddrähte 10 zwischen Schaltungsteil 7 und Leiterfolie 9 elektrisch miteinander verbunden und ein das Schaltungsteil 7 abdeckendes Gel in die Aussparung 31 eingebracht Nach dem Auftragen des Gels kann dies ausgehärtet werden. Zum Schluss wird das zweite Gehäuseteil 14 mit dem zweiten Dichtelement 13 auf die Leiterfolie 9 aufgesetzt, wobei die Befestigungselemente durch Ausnehmungen 37 des zweiten Gehäuseteils greifen, und der Stapel mit der Kraft F zusammengedrückt, so dass der Gehäuseinnenraum 16 öldicht abgeschlossen wird

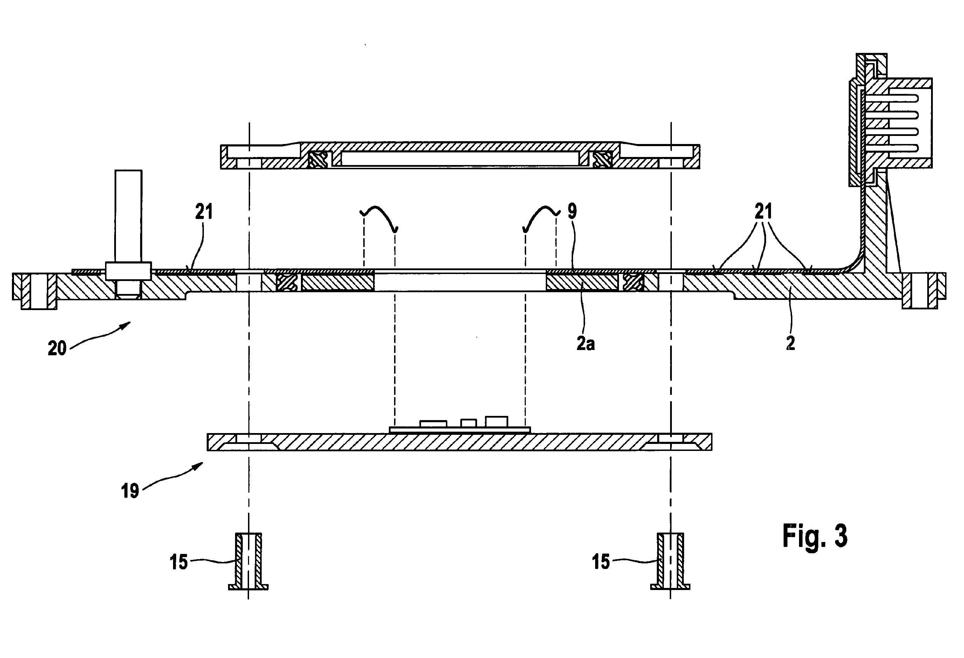

Fig. 3 zeigt wie ein zweites Ausführungsbeispiel des erfindungsgemäßen Steuermoduls mittels vorprüfbarer Baugruppen hergestellt wird. Bei diesem Ausführungsbeispiels ist keine Abdeckung 18 vorgesehen. Stattdessen wird die flexible Leiterfok 9 nicht nur auf das Rahmenteil 2a sondern mittels eines Klebers 21 auch auf das Stützteil 2 aufgeklebt. Diese Verklebung kann über die gesamte Auflagerfläche der großflächigen flexiblen Leiterfolie 9 auf dem Träger oder auch nur wie in Fig. 3 gezeigt in Teilbereichen erfolgen.

Falls das Stützteil 2 als Spritzgussteil aus Kunststoffhergestellt wird, kann die flexible Leiterfolie 9 in einem dritten Ausführungsbeispiel auch in das Stützteil 2 eingespritzt werden.

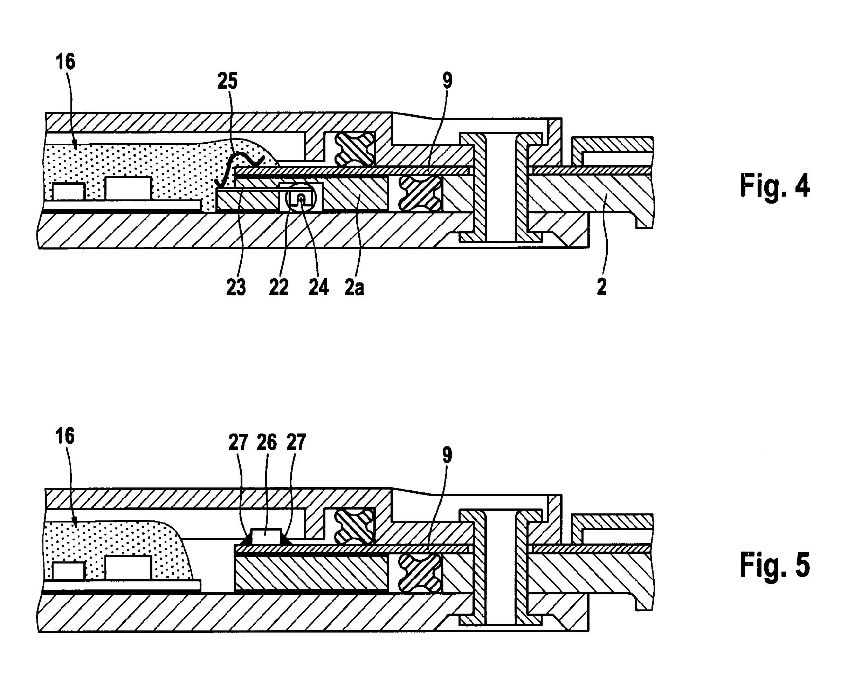

Fig. 4 zeigt einen Teilausschnitt eines Querschnitts durch ein viertes Ausführungsbeispiel der Erfindung. In diesem Ausführungsbeispiel sind einzelne elektronische Bauelemente 22 vom Schalungsteil 7 ausgelagert und innerhalb des Rahmenteils 2a im Gehäuseinnenraum 16 angeordnet. Diese Auslagerung kann vorteilhaft sein, um das Schattungsteil 7 verkleinern zu können. Insbesondere recht große Bauelemente können daher an anderer Stelle außer dem Schaltungsteil 7 angeordnet werden. So kann beispielsweise eine Drahtbauelement mit einem in dem Rahmenteil eingelassenen elektrischen Leiter 23 in Form eines Stanzgitterteils beispielsweise durch Gabelschweiβung 24 elektrisch kontaktiert werden. Die elektrische Kontaktierung des Leiters 23 mit Leiterbahnen der Leiterfolie 9 erfolgt vorteilhafter Weise mittels Bonddrähten 25, die im gleichen Verbindungsprozess und mit den gleichen Bondmitteln, wie die Bondrähte 10 zwischen flexibler Leiterfolie und Schaltungsträger 7 hergestellt werden können. Die Anordnung der Bauelemente 22 in einer Aussparung des Rahmenteils 2a, die durch das erste Gehäuseteil 6 abgeschlossen wird, bietet zusätzlich den Vorteil, dass das Bauelement 22 allseitig gut gekammert und mechanisch in seiner Lage gesichert ist, was eine hohe Robustheit bei Schwingungs- und Vibrationsbelastungen bewirkt.

Ein fünftes Ausführungsbeispiel ist in Fig. 5 dargestellt Hier ist ein einzelnes elektrische Bauelement 26 innerhalb des öldichten Gehäuseinnenraumes 16 direkt aufAnschlussflächen der flexiblen Leiterfolie 9 aufgesetzt und damit elektrisch verbunden. Es kann sich hier beispielsweise um ein SMD-Bauelement (surface mounted device) handeln. Wir in Fig. 5 dargestellt, ist das Bauelement 26 auf der freien Seite der flexiblen Leiterfolie 9 mittels eine Kontaktklebers 27 elektrisch und mechanisch an die Leiterfolie angebunden.

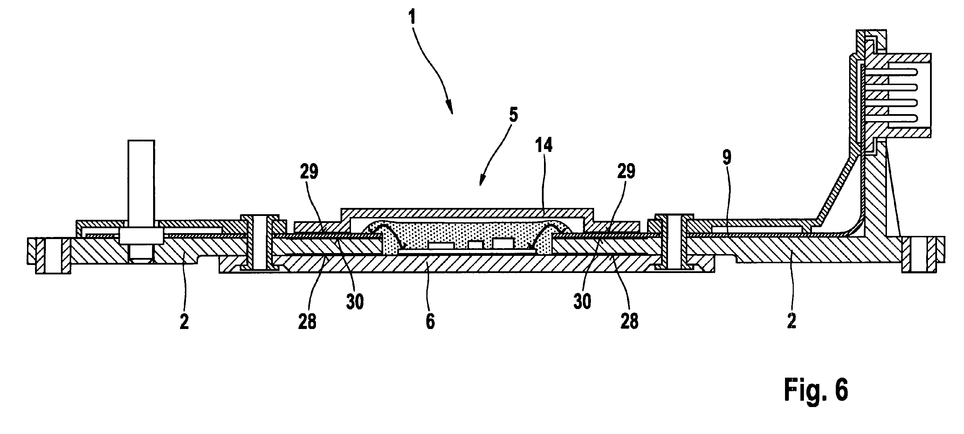

Fig. 6 zeigt ein sechstes Ausführungsbeispiel des Steuermoduls 1, bei dem der Träger 2 einteilig ausgebildet ist und die Abdichtung des Steuergerätes 5 nicht über Dichtelemente, sondern mittels eines Dichtklebers, beispielsweise ein Epoxidkleber oder ein Acrylkleber, erfolgt. Herzu wird ein das Schaltungsteil 7 umgebender Abschnitt des Trägers 2 mit der Unterseite über die umlaufende Kleberschicht 28 auf die Innenseite 6a des ersten Gehäuseteils 6 dicht aufgeklebt. Die flexible Leiterfolie 9 ist auf die von dem ersten Gehäuseteil 6 abgewandte Seite des Trägers 2 über die umlaufende Kleberschicht 30 dicht aufgeklebt. Auf der von dem Träger 2 abgewandten Seite der flexiblen Leiterfolie 9 ist das zweite Gehäuseteil 14 über eine dritte umlaufende Kleberschicht 29 dicht auf die flexible Leiterfolie 9 aufgeklebt. In diesem Ausfürhrungsbeispiels werden also das erste und zweite Dichtelement des ersten Ausführungsbeispiels durch Dichtkleber ersetzt und die im ersten Ausführungsbeispiel zur Fixierung vorhandene Klebung zwischen Leiterfolie und Träger mittels eines Dichtklebers ausgeführt. Besonders vorteilhaft an diesem Ausführungsbeispiel ist, dass der Träger 2 als quasi drittes Gehäuseteil einstückig direkt in das Steuergerät 5 hineingeführt ist und so eine starre, die Montage erleichternde Baugruppe für die Verbindungsfunktionen erhalten wird. Das Einlegen der Dichtelemente entfällt.

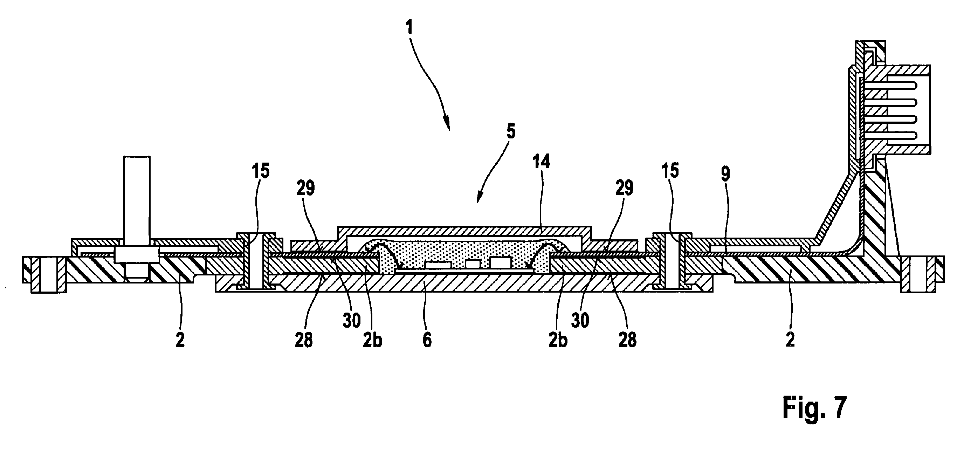

Fig. 7 zeigt ein siebtes Ausführungsbeispiel der Ereindung, In diesem Ausführungsbeispiel ist der Träger 2 als Verbundteil im Bereich 2b der Kleberschichten 28, 29 und der Befestigungselemente 15 partiell aus Metall, vorzugsweise Aluminium ausgeführt. Der restliche Teil des Trägers 2 wird vorzugsweise als Kunststonspritzteil ausgebildet. Hier ergibt sich der Vorteil, dass im Bereich der Klebeverbindungen gleichartige Materialien mit gleichartigen Ausdehnungskoeflizienten verklebt werden.

Es versteht sich, dass die gezeigten Ausführungsbeispiele auch untereinander kombinierbar sind und von der Erfindung beispielsweise Ausführungen umfasst werden, bei denen nur eines der Dichtelemente aus Fig. 1 durch eine Dichtklebung ersetzt wird, beziehungsweise eine der Dichtklebungen in Fig. 6 und Fig. 7 durch ein Dichtelement ersetzt wird. Natürlich sind auch Kombinationen der Ausführungsbeispiele aus Fig. 4 und/oder Fig. 5 mit den Ausführungsbeispielen aus Fig. 6 und 7 möglich.

### Bezugszeichenliste

- 1.: Steuermodul
- 2.: Träger
- 2a.: Rahmenteil
- 2b.: Bereich
- 3.: Steckerteil
- 4.: Sensor
- 5.: Steuergerät
- 6.: erstes Gehäuseteil
- 6a.: Innenseite
- 7.: elektronisches Schaltungsteil
- 8.: Bauelemente
- 9.: flexible Leiterfolie
- 10.: Bondrähte
- 12.: erstes Dichtelement
- 13.: zweites Dichtelement
- 14.: zweites Gehäuseteil
- 15.: Befestigungsmittel
- 16.: Gehäuseinnenraum
- 17.: Abdeckmaterial
- 18.: Abdeckung
- 19.: erste Baugruppe
- 20.: zweite Baugruppe
- 21.: Kleber
- 22.: Bauelement
- 23.: Leiter
- 24.: Gabelschweißung
- 25.: Bonddraht
- 26.: Bauelement
- 27.: Kontaktkleber
- 28, 29, 30.: Kleberschichten
- 31.: Aussparung
- 32.: Zwischenraum
- 33.: Kragen
- 34, 35, 36.: Ausnehmungen

## Patentansprüche

1. Steuermodul, insbesondere für ein Kraftfahrzeuggetriebe, mit einem ersten Gehäuseteil (6), auf dem ein elektronisches Schaltungsteil (7) angeordnet ist, einem zweiten Gehäuseteil (14) und mit einem am Kraftfahrzeuggetriebe festlegbaren Träger (2) aus Metall oder kunststoff, an dem eine flexible Leiterfolie (9) angeordnet ist, die in einem zwischen dem ersten Gehäuseteil und dem zweiten Gehäuseteil befindlichen Gehäuseinnenraum (16) mit dem Schaltungsteil und die außerhalb des Gehäuseinnenraums mit an dem Träger (2) festgelegten elektrischen Bauelementen (4, 3) elektrisch verbunden ist, **gekennzeichnet durch** einen stapelförmigen Aufbau, bei dem
- der Träger (2, 2a, 2b) mit einer ersten Seite auf einer mit dem Schaltungsteil versehenen Innenseite (6a) des ersten Gehäuseteils (6) aufliegend angeordnet ist,
- das Schaltungsteil (7) in einer Aussparung (31) des Trägers (2, 2a, 2b) angeordnet ist und mit der flexiblen Leiterfolie (9) vorzugsweise über Bondrahtverbindungen (10) kontaktiert ist,
- die flexible Leiterfolie (9) auf der von dem ersten Gehäuseteil (6) abgewandten zweiten Seite des Trägers (2, 2a, 2b) angeordnet ist und
- das zweite Gehäuseteil (14) auf die flexible Leiterfolie (9) aufgesetzt ist.

2. Steuermodul nach Anspruch 1, **dadurch gekennzeichnet, dass** der Träger (2, 2a) zweiteilig ausgebildet ist, mit einem das Schaltungsteil umgebenden Rahmenteil (2a) und einem das Rahmenteil umgebenden Stützteil (2), wobei das Rahmenteil (2a) über einen Zwischenraum (32) von dem Stützteil (2) beabstandet ist, in welchem Zwischenraum ein erstes Dichtelement (12) angeordnet ist, das einerseits an der Innenseite (6a) des ersten Gehäuseteils (6) und andererseits an der flexiblen Leiterfolie (9) dichtend anliegt (Fig. 1, Fig. 4, Fig. 5)

3. Steuermodul nach Anspruch 1, **dadurch gekennzeichnet, dass** zwischen dem Träger (2, 2b) und der Innenseite (6a) des ersten Gehäuseteils (6) ein Dichtkleber (28) angeordnet ist. (Fig. 6, Fig. 7)

4. Steuermodul nach Anspruch 1, 2 oder 3, **dadurch gekennzeichnet, dass** ein zweites Dichtelement (13) vorgesehen ist, das einerseits an der flexiblen Leiterfolio (2) und andererseits an dem zweiten Gehäuseteil (14) dichtend anliegt. (Fig. 1, Fig. 4, Fig. 5)

5. Steuermodul nach Anspruch 1, 2 oder 3, **dadurch gekennzeichnet, dass** zwischen dem zweiten Gehäuseteil (14) und der Leiterfolie (9) ein Dichtkleber (29) angeordnet ist. (Fig. 6, Fig. 7)

6. Steuermodul nach ein Anspruch 1, **dadurch gekennzeichnet, dass** auf einen Bereich der flexiblen Leiterfolie (9) außerhalb des durch das zweite Gehäuseteil (14) abgedeckten Bereiches eine Abdeckung (18) aufgesetzt ist, die an dem Träger (2, 2a) befestigt ist. (Fig. 1)

7. Steuermodul nach Anspruch 1, **dadurch gekennzeichnet, dass** der Träger (2, 2b) als Verbundteil aus einem das Schaltungsteil (7) umgebenden Rahmenteil (2b) und einem sich an das Rahmenteil außerhalb des Gehäuseinnenraums (16) anschlieβenden Stützteil (2) ausgebildet ist. (Fig. 7)

8. Steuermodul nach einem der vorstehenden Ansprüche, **dadurch gekennzeichnet, dass** der aus erstem Gehäuseteil (6), Träger (2, 2a, 2b), flexibler Leiterfolie (9) und zweitem Gehäuseteil (14) gebildete Stapel mittels wenigstens eines Befestigungselementes (15) zusammengehalten wird.

9. Steuermodul nach Anspruch 8, **dadurch gekennzeichnet, dass** der aus erstem Gehäuseteil (6), Träger (2, 2a, 2b), flexibler Leiterfolie (9) und zweitem Gehäuseteil (14) gebildete Stapel wenigstens eine Ausnehmung aufweist, in die wenigstens ein den Stapel zusammenhaltendes Befestigungselement (15) eingebracht ist.

10. Steuermodul nach einem der vorstehenden Ansprüche, **dadurch gekennzeichnet, dass** zwischen dem ersten Gehäuseteil (6) und dem zweiten Gehäuseteil (14) wenigstens ein elektrisches Bauelement (22) in einer Aussparung des Trägers (2, 2a, 2b) angeordnet ist und über elektrische Verbindungselemente (23, 25) mit der flexiblen Leiterfolie (9) kontaktiert ist (Fig. 4)

11. Steuermodul nach einem der vorstehenden Ansprüche, **dadurch gekennzeichnet, dass** im Gehäuseinnenraum (16) zwischen dem ersten Gehäuseteil (6) und dem zweiten Gehäuseteil (14) wenigstens ein elektrisches Bauelement (26) auf die Leiterfolie (9) aufgebracht und mit dieser elektrisch kontaktiert ist (Fig. 5)

12. Verfahren zur Herstellung eines Steuermoduls nach einem der Ansprüche 1 bis 11, **dadurch gekennzeichnet, dass** das erste Gehäuseteils (6) mit dem darauf aufgebrachten Schaltungsteil (7) als eine erste Baugruppe (19) hergestellt wird und unabhängig davon der Träger (2, 2a) mit den daran angeordneten elektrischen Bauelementen (3, 4) und der darauf angeordneten flexiblen Leiterfolie (9) und gegebenenfalls mit der Abdeckung (18) als eine zweite Baugruppe (20) hergestellt wird, dass die zweite Baugruppe (20) auf die erste Baugruppe (19) aufgesetzt wird und das elektrische Schaltungsteil (7) mit der flexiblen Leiterfolie (9) anschließend vorzugsweise über Bonddrahtverbindungen (10) kontaktiert wird. (Fig. 2, Fig. 3)

13. Verfahren nach Anspruch 12, **dadurch gekennzeichnet, dass** nach der Montage der beiden Baugruppen (19, 20) und gegebenenfalls nach der Einbringung eines Abdeckmaterials (17) über dem Schaltungsteil (7) das zweite Gehäuseteil (14) auf die flexible Leiterfolie (9) aufgebracht und das erste Gehäuseteil, der Träger, die flexible Leiterfolie und das zweite Gehäuseteil mittels wenigstens eines Befestigungselementes (15) aneinander festgelegt werden.

## Claims

1. Control module, in particular for a motor vehicle transmission, comprising a first housing part (6) on which an electronic circuit part (7) is arranged, a second housing part (14) and comprising a carrier (2) composed of metal or plastic, which can be fixed to the motor vehicle transmission and on which is arranged a flexible conductor film (9) electrically connected, in a housing interior (16) situated between the first housing part and the second housing part, to the circuit part and electrically connected, outside the housing interior, to electrical components (4, 3) fixed to the carrier (2), **characterized by** a stacked construction in which
- the carrier (2, 2a, 2b) is arranged in a manner bearing with a first side on an inner side (6a) of the first housing part (6), said inner side being provided with the circuit part,
- the circuit part (7) is arranged in a cutout (31) of the carrier (2, 2a, 2b) and is contact-connected to the flexible conductor film (9) preferably by means of bonding wire connections (10),
- the flexible conductor film (9) is arranged on the second side of the carrier (2, 2a, 2b), said second side being remote from the first housing part (6), and
- the second housing part (14) is placed onto the flexible conductor film (9).

2. Control module according to Claim 1, **characterized in that** the carrier (2, 2a) is embodied in two parts, comprising a frame part (2a) surrounding the circuit part, and a supporting part (2) surrounding the frame part, wherein the frame part (2a) is spaced apart from the supporting part (2) by means of an interspace (32), in which interspace is arranged a first sealing element (12), which bears in sealing fashion against the inner side (6a) of the first housing part (6), on the one hand, and against the flexible conductor film (9), on the other hand. (Figure 1, Figure 4, Figure 5)

3. Control module according to Claim 1, **characterized in that** a sealing adhesive (28) is arranged between the carrier (2, 2b) and the inner side (6a) of the first housing part (6). (Figure 6, Figure 7)

4. Control module according to Claim 1, 2 or 3, **characterized in that** a second sealing element (13) is provided, which bears in sealing fashion against the flexible conductor film (9), on the one hand, and against the second housing part (14), on the other hand. (Figure 1, Figure 4, Figure 5)

5. Control module according to Claim 1, 2 or 3, **characterized in that** a sealing adhesive (29) is arranged between the second housing part (14) and the conductor film (9). (Figure 6, Figure 7)

6. Control module according to Claim 1, **characterized in that** a cover (18) is placed onto a region of the flexible conductor film (9) outside the region covered by the second housing part (14), said cover being fastened to the carrier (2, 2a). (Figure 1)

7. Control module according to Claim 1, **characterized in that** the carrier (2, 2b) is embodied as a composite part composed of a frame part (2b) surrounding the circuit part (7) and a supporting part (2) adjacent to the frame part outside the housing interior (16). (Figure 7)

8. Control module according to any of the preceding claims, **characterized in that** the stack formed from first housing part (6), carrier (2, 2a, 2b), flexible conductor film (9) and second housing part (14) is held together by means of at least one fastening element (15).

9. Control module according to Claim 8, **characterized in that** the stack formed from first housing part (6), carrier (2, 2a, 2b), flexible conductor film (9) and second housing part (14) has at least one cutout into which at least one fastening element (15) that holds the stack together is introduced.

10. Control module according to any of the preceding claims, **characterized in that**, between the first housing part (6) and the second housing part (14), at least one electrical component (22) is arranged in a cutout of the carrier (2, 2a, 2b) and is contact-connected to the flexible conductor film (9) by means of electrical connecting elements (23, 25). (Figure 4)

11. Control module according to any of the preceding claims, **characterized in that**, in the housing interior (16) between the first housing part (6) and the second housing part (14), at least one electrical component (26) is applied to the conductor film (9) and electrically contact-connected thereto. (Figure 5)

12. Method for producing a control module according to any of Claims 1 to 11, **characterized in that** the first housing part (6) with the circuit part (7) applied thereto is produced as a first assembly (19) and, independently thereof, the carrier (2, 2a) with the electrical components (3, 4) arranged thereon and the flexible conductor film (9) arranged thereon and, if appropriate, with the cover (18) is produced as a second assembly (20), and **in that** the second assembly (20) is placed onto the first assembly (19) and the electrical circuit part (7) is subsequently contact-connected to the flexible conductor film (9) preferably by means of bonding wire connections (10). (Figure 2, Figure 3).

13. Method according to Claim 12, **characterized in that**, after the mounting of the two assemblies (19, 20) and, if appropriate, after the introduction of a covering material (17) over the circuit part (7), the second housing part (14) is applied to the flexible conductor film (9) and the first housing part, the carrier, the flexible conductor film and the second housing part are fixed to one another by means of at least one fastening element (15).

## Revendications

1. Module de commande, en particulier pour une transmission de véhicule automobile, qui présente
une première partie (6) de boîtier sur lequel est disposée une partie (7) formant un circuit électronique,
une deuxième partie (14) de boîtier dotée d'un support (2) en métal ou en matière synthétique apte à être fixé sur la transmission du véhicule automobile et sur lequel est disposée une feuille conductrice flexible (9) qui est reliée électriquement à la partie formant un circuit dans un espace intérieur (16) du boîtier situé entre la première partie de boîtier et la deuxième partie de boîtier et qui est reliée électriquement à l'extérieur de l'espace intérieur du boîtier à des composants électriques (4, 3) fixés sur le support (2),
**caractérisé par**
une structure empilée dans laquelle
le support (2, 2a, 2b) est placé à plat par un premier côté sur le côté intérieur (6a), doté de la partie formant un circuit, de la première partie (6) du boîtier,
la partie (7) formant un circuit est disposée dans une découpe (31) du support (2, 2a, 2b) et est mise en contact avec la feuille conductrice flexible (9) de préférence par des liaisons (10) par fils,
la feuille conductrice flexible (9) est disposée sur le deuxième côté, non tourné vers la première partie (6) du boîtier, du support (2, 2a, 2b) et
la deuxième partie (14) du boîtier est placée sur la feuille conductrice flexible (9).

2. Module de commande selon la revendication 1, **caractérisé en ce que** le support (2, 2a) est configuré en deux parties, à savoir une partie d'encadrement (2a) qui entoure la partie formant un circuit et une partie de soutien (2) qui entoure la partie d'encadrement, **en ce que** la partie d'encadrement (2a) est maintenue à distance de la partie de soutien (2) grâce à un espace intermédiaire (32) et **en ce qu'**un premier élément d'étanchéité (12) qui repose de manière étanche d'une part sur le côté intérieur (6a) de la première partie (6) du boîtier et d'autre part sur la feuille conductrice flexible (9) est disposé dans cet espace intermédiaire (figure 1, figure 4, figure 5).

3. Module de commande selon la revendication 1, **caractérisé en ce qu'**un adhésif d'étanchéité (28) est disposé entre le support (2, 2b) et le côté intérieur (6a) de la première partie (6) du boîtier (figure 6, figure 7).

4. Module de commande selon les revendications 1, 2 ou 3, **caractérisé en ce qu'**il présente un deuxième élément d'étanchéité (13) qui repose de manière étanche d'une part sur la feuille conductrice flexible (2) et d'autre part sur la deuxième partie (14) du boîtier (figure 1, figure 4, figure 5).

5. Module de commande selon les revendications 1, 2 ou 3, **caractérisé en ce qu'**un adhésif d'étanchéité (29) est disposé entre la deuxième partie (14) du boîtier et la feuille conductrice (9) (figure 6, figure 7).

6. Module de commande selon la revendication 1, **caractérisé en ce qu'**à l'extérieur de la partie recouverte par la deuxième partie (14) du boîtier, un couvercle (18) fixé sur le support (2, 2a) est placé sur une partie de la feuille conductrice flexible (9) (figure 1).

7. Module de commande selon la revendication 1, **caractérisé en ce que** le support (2, 2b) est configuré comme partie composée d'une partie d'encadrement (2b) qui entoure la partie (7) formant un circuit et d'une partie de soutien (2) qui se raccorde à la partie d'encadrement à l'extérieur de l'espace intérieur (16) du boîtier (figure 7).

8. Module de commande selon l'une des revendications précédentes, **caractérisé en ce que** la pile formée de la première partie (6) du boîtier, du support (2, 2a, 2b), de la feuille conductrice flexible (9) et de la deuxième partie (14) du boîtier est maintenue au moyen d'au moins un élément de fixation (15).

9. Module de commande selon la revendication 8, **caractérisé en ce que** la pile formée de la première partie (6) du boîtier, du support (2, 2a, 2b), de la feuille conductrice flexible (9) et de la deuxième partie (14) du boîtier présente au moins une découpe dans laquelle au moins un élément de fixation (15) qui maintient la pile est placé.

10. Module de commande selon l'une des revendications précédentes, **caractérisé en ce qu'**au moins un composant électrique (22) est disposé entre la première partie (6) du boîtier et la deuxième partie (14) du boîtier dans une découpe du support (2, 2a, 2b) et est mise en contact avec la feuille conductrice flexible (9) par l'intermédiaire d'éléments (23, 25) de raccordement électrique (figure 4) .

11. Module de commande selon l'une des revendications précédentes, **caractérisé en ce qu'**au moins un composant électrique (26) est placé sur la feuille conductrice (9) dans l'espace intérieur (16) du boîtier, entre la première partie (6) du boîtier et la deuxième partie (14) du boîtier, et est mis en contact électrique avec cette feuille conductrice (figure 5).

12. Procédé de fabrication d'un module de commande selon l'une des revendications 1 à 11, **caractérisé en ce que** la première partie (6) du boîtier sur laquelle la partie (7) formant un circuit est placée est fabriquée sous la forme d'un premier ensemble (19) et, de manière indépendante, le support (2, 2a) sur lequel sont placés des composants électriques (3, 4) et la feuille conductrice flexible (9) ainsi qu'éventuellement le couvercle (18) est fabriqué sous la forme d'un deuxième ensemble (20), **en ce que** le deuxième ensemble (20) est placé sur le premier ensemble (19) et la partie (7) formant un circuit électrique est ensuite mise en contact avec la feuille conductrice flexible (9), de préférence par des raccordements (10) par fils (figure 2, figure 3).

13. Procédé selon la revendication 12, **caractérisé en ce qu'**après le montage des deux ensembles (19, 20) et éventuellement après placement d'un matériau de recouvrement (17) au-dessus de la partie (7) formant un circuit, la deuxième partie (14) du boîtier est placée sur la feuille conductrice flexible (9) et la première partie du boîtier, le support, la feuille conductrice flexible et la deuxième partie du boîtier sont fixés les uns aux autres au moyen d'un élément de fixation (15).
